# EUROPEAN PATENT APPLICATION

(11) **EP 2 290 680 A1**
(43) Date of publication of application: **02.03.2011**
(21) Application number: 09168783.0
(22) Date of filing: 27.08.2009
(51) Int. Cl.: H01L 23/373

(54) **Power semiconductor module**

(71) Applicant: ABB Research Ltd., 8050 Zürich (CH)
(72) Inventor: Schulz, Nicola, 5300 Turgi (CH); Duran, Hamit, 5300 Turgi (CH)
(74) Representative: ABB Patent Attorneys

(57) **Abstract**

A power semiconductor module comprising at least one power semiconductor element (1, 1', 1") mounted on a substrate (2) and a base plate (3) thermally connected to the substrate (2) by a joint material (4) having a melting point lower than the operating temperature of the power semiconductor module.

## Description

The invention relates to a power semiconductor module.

Power semiconductor modules comprise power semiconductor elements which are mounted on a substrate comprising an electrically insulating layer mode from e.g. ceramics or an epoxy- or polymer-based material. The ceramic substrate is mounted on a metal base plate for carrying away heat produced in the power semiconductor element. For optimally conveying the heat of substrate to the base plate, a large joint area and good thermal contact between the substrate and the base plate is needed. Normally, the substrate is soldered by a large area solder joint to the base plate. Due to the thermal cycling which is occurring typically in traction applications, the solder joint is exposed to large forces. These forces origin from different expansion behaviors of different materials during the thermal cycles due to different thermal coefficients of expansion of the substrate and the base plate. Often this leads to damages of the solder joint and intensively reduces the heat conduction capability of the power semiconductor module.

Therefore, the base plate is normally produced by materials having similar thermal coefficients of expansion than the substrate as for example AlSiC. However, AlSiC is expensive and its thermal conductivity is not optimal. Contrary, copper is cheap and has a very high thermal conductivity, but shows a high thermal coefficient of expansion which leads to a rapid delamination of the solder layer under temperature cycling with temperatures used in normal traction applications.

DE 196 47 590 A1 proposes to use an additional plate between a copper base plate and a ceramic substrate, wherein the additional plate has a thermal coefficient of expansion between those of the base plate and the ceramic substrate. However, this enlarges the power semiconductor module, increases the price for the power semiconductor module and necessitates additional steps of mounting.

The object of the invention is to find a cheap joint between the substrate and the base plate with a high thermal conductivity and with a good resistance against thermal cycling.

The object is solved by a power semiconductor module according to claim 1. The power semiconductor module comprises at least one power semiconductor element mounted on at least one substrate. A base plate is thermally connected to the substrate by a liquid joint material having a melting point lower than the operating temperature of the power semiconductor module.

During an operation of the power semiconductor module, the joint material is in a liquid state or becomes liquid, because the joint material is heated above the melting point. Thus, tension stress in the joint material due to different expansion coefficients of the substrate and the base plate can efficiently be reduced in the joint material being in a liquid phase. The melting point of a material refers to the conditions, where a material melts, normally temperature and pressure. Since the melting point of many materials, especially metals does not strongly depend on the pressure, the pressure can even be neglected. The melting temperature at normal pressure is exact enough for large pressure ranges of use, because the temperature change of thermal cycling is much larger than the melting temperature change under a change of the pressure conditions.

The dependent claims refer to advantageous embodiments of the invention.

In one embodiment according to the invention, the joint material has a melting point being higher than the normal temperature of the ambience. This has the advantage that the switched off power semiconductor module shows an easy handling for example during mounting without problems of volatilizing liquid. In an alternative embodiment, the joint material has a melting point lower than the ambience temperature.

In one embodiment according to the invention, a plurality of power semiconductor elements is mounted on the same substrate. This is especially advantageous in combination with the connection of the common substrate with the base plate by said joint material, because a very large surface of a substrate can robustly and cheap be joined to the base plate and the heat of several power semiconductor elements can be transported over a large area to the base plate. Especially, if only a part of the plurality of power semiconductor elements is working, only a part of the substrate, base plate and joint material is heated up and expanded while the remaining parts of the substrate, base plate and joint material remain cool. Thus, the burden for the joint material is still higher and the stress for the locally heated up joint material can be relieved by the joint material being liquid or becoming liquid during the heat up process. Even, if the joint material remains solid in the remaining cold parts of the substrate, damages in the joint material are closed at the next heat up process, when the joint material becomes liquid again, damages are closed and optimal thermal conductivity is restored. In addition, a plurality of power semiconductors can be mounted on only one substrate and the substrate with the plurality of power semiconductors has to be connected to the base plate via the joint material only once. Thus, the number of process steps is reduced and still a robust and efficient joint between the substrate and the base plate is achieved.

In one embodiment according to the invention, the joint material is a metal. The advantage of metals is that they have good thermal conductivity and their melting temperature is well-defined and does not depend on pressure.

In one embodiment according to the invention, the substrate comprises an electrically insulating material for example silicon oxide, aluminium nitride, silicon nitride or an epoxy-based material. In an alternative embodiment, the substrate mainly consists of metal.

In one embodiment according to the invention, the base plate as a major material comprises copper. This is especially advantageous with the present invention, since copper is very cheap and shows a high thermal conductivity and in combination with said joint material, the high thermal coefficients of expansion do not affect the stability of the power semiconductor module anymore. A copper base plate is even advantageous in combination with metallic joint material, because in states, when the joint material becomes solid, the joint material can be efficiently bonded to the copper base plate.

In one embodiment according to the invention, the joint material between the substrate and the base plate is covered laterally by a solid material, for example an organic material. Thus, the joint material in a liquid state cannot flow out of the gap between the substrate and the base plate. In addition, any reaction with the ambient medium is prevented. Organic materials for the solid material are advantageous, because of their low reactivity especially with metals and their cheap production and their easy handling. In an alternative embodiment, the joint material is open to ambience. In a liquid state of the joint material, air or any other ambient medium enclosed between the substrate or the base plate and the joint material can be conveyed to the ambience and the thermal conductivity of the joint between the substrate and the base plate keeps high.

In one embodiment according to the invention, the base plate comprises a recess wherein substrate is mounted by the joint material. The recess is within one side of the base plate such that there is a step up from the recess region into the remaining region of the base plate. Thus, the joint material and the substrate are enclosed by a wall created by the recess such that the joint material in a liquid state cannot flow away.

All embodiments of the invention or single features can be combined advantageously of course.

In the following, different embodiments of the inventive power semiconductor module will be explained in detail on the basis of the drawings. The drawings show:
- Fig. 1: a first embodiment of the power semiconductor module according to the invention;
- Fig. 2: a second embodiment of the power semiconductor module according to the invention with encasement of the joint material;
- Fig. 3: a third embodiment of the power semiconductor module according to the invention with a recess in the base plate; and
- Fig. 4: a fourth embodiment of the power semiconductor module according to the invention with a recess in the base plate and with an encasement of the joint material.

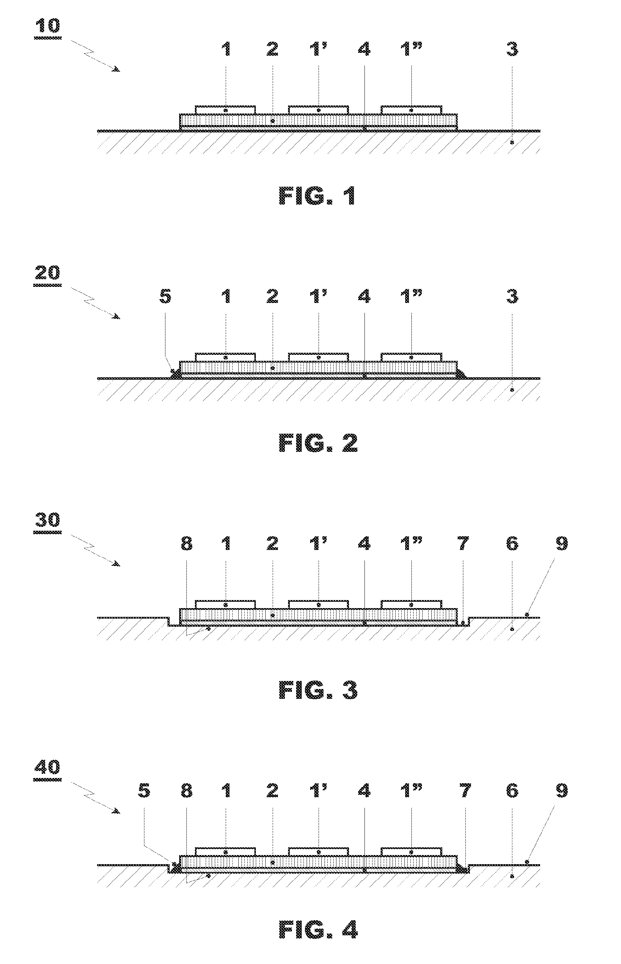

Figure 1 shows a power semiconductor module 10 as a first embodiment of the invention. Three power semiconductor elements 1, 1' and 1" are mounted on a substrate 2. Examples of power semiconductors are diodes like PiN diode or Schottky diode, power metal oxide semiconductor field-effect transistors, insulated-gate bipolar transistors or thyristors. The invention is not restricted to three power semiconductor elements 1, 1' and 1" but can even show only one or even a plurality of such elements, which can be different or equal. The power semiconductor elements 1, 1' and 1" produce a large amount of heat during operation which is conducted over the substrate 2 to a base plate 3 as heat sink. Consequently, during operation the operating temperature of the power semiconductor module will be significantly higher than normal ambient temperature.
"Normal ambient temperature" is considered to cover an ambient temperature range in which the power semiconductor is supposed to be used according to its specification.

The substrate 2 here is made of an insulating material with good heat conductivity such as aluminium nitride or silicon nitride. However, sometimes even metallic substrates or other materials are used.

The substrate 2 is connected to the base plate 3 by a metallic joint material 4 which has a melting point lower than the operating temperature of the power semiconductor elements 1, 1' and 1". The operating temperature is an average temperature of that side of the substrate 2 that contacts the liquid material 4 when all of the power semiconductor elements 1, 1', 1" are operating in their regular mode of use. Thus, the joint material 4 is or becomes liquid during the operation of the power semiconductor elements 1, 1' and 1" such that there does not arise any tension in the joint material 4 by different expansions of the substrate and the base plate or by different expansions of areas of the substrate due to temperature gradients therein. Normal operating temperatures are for example 50 °C to 200 °C.

The joint material 4 is chosen such that the melting point lies between the operating temperature and the ambience temperature such that the joint material 4 remains solid while the power semiconductor elements 1, 1' and 1" are not working. Therefore, the power semiconductor module 10 can be handled without paying attention to a liquid joint material 4 for example during mounting the power semiconductor module 10. The power semiconductor module 10 should be mounted such that the gravitation forces the substrate 2 to the base plate 3 in the direction of the normal of the base plate. To ensure that diving during operation the liquid phase is reached the melting temperature should be well below the lower limit of the operating temperature range, for example by 20 K.

Alternatively, the joint material 4 can be chosen such that the melting point is nearly the maximum temperature of the power semiconductor elements 1, 1' and 1" such that the joint material 4 mainly remains solid and melts only during some maximum temperature where tension stress could cause problems. This has the advantage that the joint between the substrate 2 and the base plate 3 is mainly solid. Only, when the power semiconductor elements 1, 1' and 1" reach their maximum temperature, the joint material 4 melts and compensates potential damages in the joint material 4. This embodiment combines easy handling of the power semiconductor module for example in traction application, wherein the power semiconductor module 10 is rotated sometimes out of a completely horizontal state and a liquid joint material 4 could flow out of the gap between the substrate 2 and the base plate 3 due to the gravitation. If a joint material 4 is used with a melting point almost at the maximum temperature of the power semiconductor elements 1, 1' and 1" , e.g. in the upper range of 150 °C to 175 °C, which still do not damage the power semiconductor elements 1, 1' and 1" , but are quite rare during operation, the joint material 4 in most cases of the operation remains solid. However, in regular repairing processes, the joint material 4 can be repaired by heating up the joint material 4 to the melting point by applying high currents to the power semiconductor elements 1, 1' and 1" such that creeps are closed and the good thermal conductivity is restored.

A second embodiment of the invention is shown in Fig. 2. The power semiconductor module 20 according to the second embodiment basically is equally designed to the first embodiment except of an encasement of the joint material 4 by a protective layer 5. Therefore, for equal elements in different embodiments of the invention, equal reference signs will be used. The protective layer 5 connects the edge of the substrate 2 around the substrate 2 with the base plate 3 such that the joint material 4 is not in contact with the ambience. The ambience can be a silicone gel, a gas like air but can even by a liquid or a solid encasement of the power semiconductor module 20. Thus, reactions of the joint material 4 with the ambience are prevented and the joint material 4 cannot flow away in a liquid state such that this embodiment is adequate for traction applications. In addition, the protective layer holds the substrate at a fixed position while the joint material 4 is in a liquid state.

Fig. 3 shows a power semiconductor module 30 according to a third embodiment of the invention. The substrate 2 and the power semiconductor elements 1, 1' and 1" are designed as in the first two embodiments. The base plate 6 of the power semiconductor module 30 shows a recess 7 within the surface of the base plate 6 oriented versus the substrate 2. In the region, where the substrate 2 is mounted on the base plate 6, the thickness of the base plate 6 is reduced such that the mounting surface 8 of the substrate 2 on the base plate 6 is situated deeper than the remaining surface 9 of the base plate 6 oriented versus the substrate 2. Thus, the thermal impedance of the base plate 6 under the substrate 2 can be further reduced due to the smaller thickness. In addition, if the region of the recess corresponds at least partly the distances of the substrate 2, the deepened part of the base plate 6 laterally holds the substrate 2. Thus, the substrate 2 is laterally fixed, but vertically free such that the substrate 2 cannot move laterally, but can compensate tensions in the vertical direction, while the joint material 4 is in a liquid state.

Fig. 4 shows a power semiconductor module 40 according to a fourth embodiment of the invention. The power semiconductor module 40 is designed similar to the power semiconductor module 30. The substrate 2 is mounted in the recess 7 of the base plate 6 with an additional protective layer 5 as presented in the second embodiment of the invention. The protective layer 5, e.g. an adhesive, can be inserted easily between the borders of the recess 7 and the edge of the substrate 2 such that the protective layer 5 stays in its desired shape until it becomes solid. This can even reduce the amount of material used for the protective layer 5. In addition, the protective layer 5 guarantees that the joint material 4 remains between the substrate 2 and the recess 7 of the base plate 6 and cannot be contaminated by the ambience gas.

The mounting surfaces of the substrate 2 and the base plate 3 or 6 are designed planar such that the thickness of the joint material 4 can be very thin for establishing a connection between substrate 2 and the base plate 3 or 6 over the complete connecting surface of the substrate 2 and the base plate 3 or 6. This increases the adhesive force between substrate 2 and the base plate 3 or 6. Thus, means for fixing the substrate may not be needed in this case.

The melting temperature of metals can be lowered until the eutectic point by impuring the metal. With this method, the melting point of metals with a good thermal conductivity can be decreased for the use as joint material 4.

The invention is not restricted to the embodiments described. All embodiments and alternatives of these embodiments of the invention can be combined with other embodiments.

## Claims

1. A power semiconductor module comprising at least one power semiconductor element (1, 1', 1") mounted on a substrate (2), the module comprising a base plate (3, 6) thermally connected to the substrate (2) by a joint material (4) having a melting point lower than the operating temperature of the power semiconductor module.

2. A power semiconductor module according to claim 1, **characterized in that** a plurality of power semiconductor elements (1, 1', 1") is mounted on one common substrate (2).

3. A power semiconductor module according to claim 1 or 2, **characterized in that** the joint material (4) comprises a metal as major material.

4. A power semiconductor module according to anyone of claims 1 to 3, **characterized in that** the substrate (2) includes of an electrically insulating material.

5. A power semiconductor module according to claim 4, **characterized in that** the electrically insulating material within the substrate (2) mainly consists of aluminium nitride, silicon oxide, silicon nitride or an epoxy- or polymer based material.

6. A power semiconductor module according to anyone of claims 1 to 3, **characterized in that** the substrate (2) mainly consists of metal.

7. A power semiconductor module according to anyone of claims 1 to 6, **characterized in that** the base plate (3, 6) mainly consisting of copper.

8. A power semiconductor module according to anyone of claims 1 to 7, **characterized in that** the joint material (4) is enclosed between the substrate (2) and the base plate (3, 6) by a solid material (5).

9. A power semiconductor module according to claim 8, **characterized in that** the solid material (5) contains an organic material.

10. A power semiconductor module according to anyone of claims 1 to 7, **characterized in that** the joint material (4) is exposed to the ambience at an outer circumference of the substrate.

11. A power semiconductor module according to anyone of claims 1 to 10, **characterized in that** the base plate (6) comprises a recess (7) wherein the substrate (2) is mounted by the joint material (4).

12. A power semiconductor module according to anyone of claims 1 to 11, **characterized in that** the joint material (4) has a melting point being higher than the normal temperature of the ambience.
